(19) Europäisches Patentamt
European Patent Office
Office européen des brevets

(11) EP 2 290 386 B1

(12) **FASCICULE DE BREVET EUROPEEN**

(45) Date de publication et mention
de la délivrance du brevet:
**20.03.2013  Bulletin 2013/12**

(51) Int Cl.:
***G01R 31/26*** *(2006.01)*

(21) Numéro de dépôt: **10173795.5**

(22) Date de dépôt: **24.08.2010**

(54) **Procédé et dispositif d'évaluation des performances électriques d'un transistor FDSOI**

Verfahren und Vorrichtung zur Auswertung der elektrischen Eigenschaften eines FDSOI Transistors

Method and apparatus for evaluation of electric performance of a FDSOI transistor

(84) Etats contractants désignés:
**AL AT BE BG CH CY CZ DE DK EE ES FI FR GB
GR HR HU IE IS IT LI LT LU LV MC MK MT NL NO
PL PT RO SE SI SK SM TR**

(30) Priorité: **28.08.2009  FR 0955895**

(43) Date de publication de la demande:
**02.03.2011  Bulletin 2011/09**

(73) Titulaire: **Commissariat à l'Énergie Atomique
et aux Énergies Alternatives
75015 Paris (FR)**

(72) Inventeurs:
  • **GARROS, Xavier
    38000, GRENOBLE (FR)**
  • **BRUNET, Laurent
    38000, GRENOBLE (FR)**

(74) Mandataire: **Ilgart, Jean-Christophe
BREVALEX
95 rue d'Amsterdam
75378 Paris Cedex 8 (FR)**

(56) Documents cités:
**US-A1- 2008 135 924    US-A1- 2009 132 974**

  • **ROMANJEK K ET AL: "High-k/metal Gate GeOI pMOSFET: Validation of the Lim&Fossum model for interface trap density extraction" 2008 IEEE INTERNATIONAL SOI CONFERENCE PROCEEDINGS, PISCATAWAY, NJ, USA, 6 octobre 2008 (2008-10-06), pages 147-148, XP031351897 ISBN: 978-1-4244-1954-8**

  • **BATUDE P ET AL: "Insights on fundamental mechanisms impacting Ge metal oxide semiconductor capacitors with high-k/metal gate stacks" JOURNAL OF APPLIED PHYSICS, AMERICAN INSTITUTE OF PHYSICS. NEW YORK, US LNKD- DOI:10.1063/1.2767381, vol. 102, no. 3, 15 août 2007 (2007-08-15) , pages 34514-34514, XP012101453 ISSN: 0021-8979**

  • **USHIKI T ET AL: "Evidence of energetically-localized trap-states at SOI-BOX interface in high-dose SIMOX wafers" SOI CONFERENCE, 1999. PROCEEDINGS. 1999 IEEE INTERNATIONAL ROHNERT PARK, CA, USA 4-7 OCT. 1999, PISCATAWAY, NJ, USA,IEEE, US LNKD- DOI: 10.1109/SOI.1999.819852, 4 octobre 1999 (1999-10-04), pages 48-49, XP010370227 ISBN: 978-0-7803-5456-2**

  • **HYUNG-KYU LIM ET AL: "THRESHOLD VOLTAGE OF THIN-FILM SILICON-ON-INSULATOR (SOI) MOSFET'S" IEEE TRANSACTIONS ON ELECTRON DEVICES, IEEE SERVICE CENTER, PISACATAWAY, NJ, US, vol. 30, no. 10, 1 octobre 1983 (1983-10-01), pages 1244-1251, XP000579751 ISSN: 0018-9383**

  • **KOEN MARTENS ET AL: "On the Correct Extraction of Interface Trap Density of MOS Devices With High-Mobility Semiconductor Substrates" IEEE TRANSACTIONS ON ELECTRON DEVICES, IEEE SERVICE CENTER, PISCATAWAY, NJ, US LNKD- DOI:10.1109/TED. 2007.912365, vol. 55, no. 2, 1 février 2008 (2008-02-01), pages 547-556, XP011200412 ISSN: 0018-9383**

• BOZYIGIT D ET AL: "On the extraction of interface trap density in the Pt/La2O3/Ge gate stack and the determination of the charge neutrality level in Ge" JOURNAL OF APPLIED PHYSICS, AMERICAN INSTITUTE OF PHYSICS. NEW YORK, US LNKD- DOI:10.1063/1.3155830, vol. 105, no. 12, 26 juin 2009 (2009-06-26), pages 124521-124521, XP012125780 ISSN: 0021-8979

**Description**

**DOMAINE TECHNIQUE**

L'invention concerne un procédé et un dispositif d'évaluation des performances électriques de transistors FDSOI, c'est-à-dire de transistors complètement désertés de type silicium sur isolant.
L'invention est notamment utilisée pour caractériser électriquement les interfaces diélectrique semi-conducteur des transistors FDSOI en évaluant les densités de défauts à ces interfaces, les performances électriques des transistors FDSOI étant directement dépendantes de la qualité de ces interfaces et donc des densités de défauts présents à ces interfaces.

**ÉTAT DE LA TECHNIQUE ANTÉRIEURE**

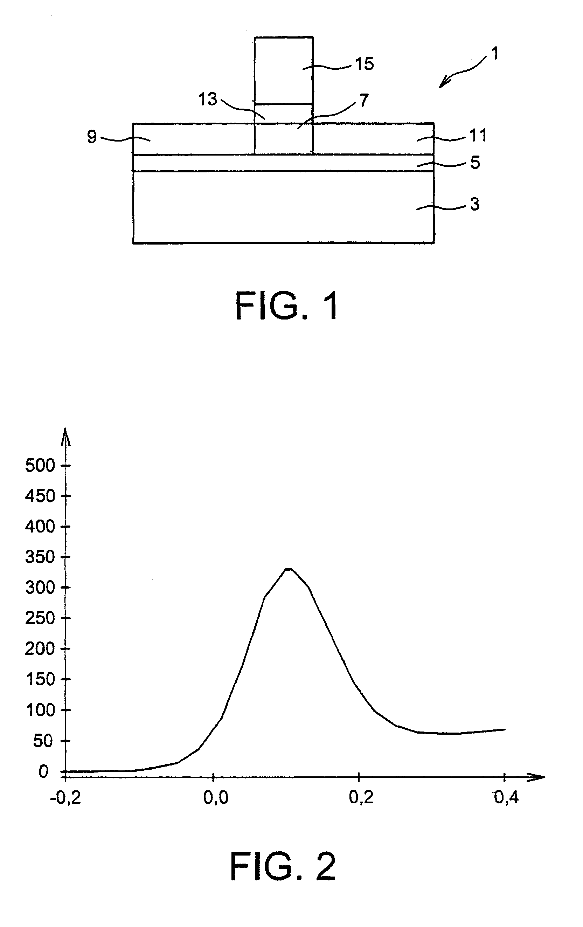

Un exemple de transistor FDSOI 1 est représenté sur la figure 1. Le transistor 1 est réalisé sur un substrat de type SOI (silicium sur isolant) comportant un substrat 3 à base de semi-conducteur, par exemple du silicium, sur lequel est disposée une couche diélectrique 5, par exemple à base de $SiO_2$, formant un diélectrique enterré (BOX) .
Une couche de semi-conducteur, tel que du silicium, dans laquelle sont formés une région de canal 7 et des régions de source 9 et de drain 11, est disposée sur la couche diélectrique 5. Le canal 7 est recouvert par un diélectrique de grille 13, par exemple à base de $SiO_2$, sur lequel est disposée une grille 15, par exemple à base de TiN.
Les performances électriques d'un tel transistor 1 de type FDSOI sont dépendantes de la qualité des interfaces silicium/$SiO_2$, à savoir l'interface entre la portion de silicium 7 destinée à former le canal et le diélectrique de grille 13, appelé interface avant, et l'interface entre la portion de silicium 7 et le diélectrique enterré 5, appelé interface arrière.
Afin d'évaluer les performances électriques de ce transistor 1, il est donc nécessaire de pouvoir mesurer et quantifier la densité de défauts à ces interfaces avant ($D_{it1}$) et arrière ($D_{it2}$).
Il existe différentes méthodes pour déterminer les densités de défauts d'interface pour un transistor bulk, c'est-à-dire un transistor réalisé sur substrat massif de semi-conducteur ne comportant pas de diélectrique enterré. Certaines de ces techniques peuvent être adaptées pour des transistors réalisés sur substrats SOI. Mais dans ce cas, elles sont soit peu précises, soit elles nécessitent l'utilisation de structures de test adaptées.
Une première méthode pour caractériser électriquement un transistor SOI consiste à se servir de la caractéristique $I_D(Vg)$ du transistor pour calculer la pente sous le seuil et en déduire la densité d'état d'interface, c'est-à-dire les densités de défauts aux interfaces du transistor. Cette caractéristique est obtenue appliquant la tension Vg sur la grille du transistor et en mesurant le courant $I_D$ sortant du drain, la source étant reliée électriquement à la masse. Cette première méthode a pour inconvénients d'être relativement imprécise et de ne pas permettre d'évaluer des densités de défauts inférieures à $10^{11}$ défauts/$cm^2$.
Une seconde méthode, appelée technique du pompage de charge, consiste, lorsqu'elle est appliquée à un transistor bulk, à mesurer le courant de substrat $I_B$ du transistor qui est proportionnel à la densité de défauts entre la portion de semi-conducteur destinée à former le canal et le diélectrique de grille. Lors de cette mesure, un signal carré est appliqué sur la grille du transistor, la source et le drain étant reliés électriquement à la masse. Bien que précise, cette méthode n'est pas utilisable sur des transistors SOI car il n'est pas possible de mesurer un courant de substrat $I_B$ compte tenu du diélectrique enterré présent entre le canal et le substrat à base de semi-conducteur.
Pour appliquer cette méthode sur des substrats SOI et notamment des transistors FDSOI, il est donc nécessaire d'utiliser des structures de tests spécifiques différentes des transistors FDSOI et comportant des interfaces diélectrique - semi-conducteur analogues aux interfaces diélectrique - semi-conducteur du transistor. Ces structures de tests peuvent être des diodes de type p-i-n comme décrit dans le document « Adaptation of the Charge Pumping Technique to Gated p-i-n Diodes Fabricated on Silicon on Insulator » de T. Ouisse et al., IEEE transactions on electron devices, 1991, vol. 38, n°6, pages 1432-1444. Ces structures de tests peuvent également être des transistors à substrat contacté comme décrit dans le document « Characterization of Front and Back Si-SiO2 Interfaces in Thick- and Thin-Film Silicon-on-Insulator MOS structures by the Charge-Pumping Technique » de D.J. Wouters et al., IEEE transactions on electron devices, 1989, vol. 36(1), n°9, pages 1746-1750.
Le document de ROMANJEK K. et al. : « High-k/metal Gate GeOI pMOSFET : Validation of the Lim&Fossum Model for Interface Trap Density Extraction », 2008 IEEE International SOI Conférence Proceedings, Piscataway, NJ, USA, 6 octobre 2008, pages 147-148, décrit un procédé d'évaluation des performances électriques d'un transistor GeOI, comportant les étapes de :

- mesure du courant de drain Id du transistor, en appliquant une tension $V_{BG} < 0$ sur le substrat à base de semi-conducteur du transistor qui est du type PMOS, en fonction d'une tension $V_G$ appliquée sur la grille du transistor,
- détermination des valeurs réelles des densités de défauts $D_{it1}$, $D_{it2}$ aux interfaces correspondantes du transistor

Le document de BATUDE P. et al. : « Insights on fundamental mechanisms impacting Ge metal oxide semiconductor capacitors with high-k/metal gate stacks », Journal of Applied Physics, New York, US, vol. 102, n°3, 15 août 2007, pages 34514-1 - 34514-8, est une étude comparant les résultats de modélisations des caractéristiques de conductance et de capacité de transistors de type GeMOS avec des mesures expérimentales de ces caractéristiques. Ce document mentionne notamment :

- une mesure de la capacité et de la conductance d'un transistor GeMOS, en fonction d'une tension VG appliquée sur la grille du transistor,
- un calcul des valeurs théoriques de la capacité et de la conductance d'un transistor modélisé par un circuit électrique équivalent au transistor, en fonction des valeurs de la tension $V_G$ appliquée au transistor modélisé et pour une valeur théorique choisie de densités de défauts $D_{it}$.

Le document US 2009/132974 A1 décrit un procédé de caractérisation d'un transistor MOSFET à plusieurs grilles, évaluant notamment la mobilité au sein du transistor.

## EXPOSÉ DE L'INVENTION

Un but de la présente invention est de proposer un procédé d'évaluation des performances électriques d'un transistor FDSOI permettant de caractériser les défauts présents à une interface entre un diélectrique de grille du transistor et un semi-conducteur destiné à former le canal du transistor et une interface entre le semi-conducteur destiné à former le canal du transistor et un diélectrique enterré du transistor, permettant en outre de détecter des densités de défauts inférieures à environ $10^{11}$ défauts/cm$^2$ qui soit précise et pouvant s'appliquer directement à des transistors FDSOI sans faire appel à des structures de test spécifiques nécessaires aux procédés de l'art antérieur.

Pour cela, la présente invention propose un procédé d'évaluation des performances électriques d'un transistor FDSOI, comportant les étapes de :

- mesure de la capacité et/ou de la conductance du transistor FDSOI, en appliquant une tension $V_{BG} > 0$ sur un substrat à base de semi-conducteur du transistor FDSOI lorsque le transistor FDSOI est du type NMOS ou une tension $V_{BG} < 0$ sur le substrat à base de semi-conducteur du transistor FDSOI lorsque le transistor FDSOI est du type PMOS, en fonction d'une tension $V_{FG}$ appliquée entre la grille et les régions de source et drain du transistor FDSOI,
- calcul des valeurs théoriques de la capacité et/ou de la conductance d'un transistor modélisé par un circuit électrique équivalent au transistor FDSOI, en fonction des valeurs des tensions $V_{FG}$ et $V_{BG}$ appliquées au transistor modélisé et pour différentes valeurs théoriques choisies de densités de défauts $D_{it1}$, $D_{it2}$ respectivement à une interface entre un diélectrique de grille du transistor modélisé et un semi-conducteur destiné à former le canal du transistor modélisé et une interface entre le semi-conducteur destiné à former le canal du transistor modélisé et un diélectrique enterré du transistor modélisé,
- détermination des valeurs réelles des densités de défauts $D_{it1}$, $D_{it2}$ aux interfaces correspondantes du transistor FDSOI par une comparaison entre les valeurs mesurées de la capacité et/ou de la conductance du transistor FDSOI et les valeurs théoriques calculées de la capacité et/ou de la conductance du transistor modélisé pour les différentes valeurs théoriques choisies des densités de défauts $D_{it1}$, $D_{it2}$ aux interfaces du transistor modélisé, et dans lequel, lorsque la conductance du transistor FDSOI est mesurée, la valeur de la tension $V_{BG}$ est choisie telle qu'une courbe représentant la conductance mesurée du transistor FDSOI en fonction de la tension $V_{FG}$ comporte au moins deux pics.

L'étape de calcul des valeurs théoriques et la comparaison réalisée au cours de l'étape de détermination des valeurs réelles des densités de défauts peuvent être réalisées sur la base des caractéristiques du transistor (capacité et/ou conductance) qui ont été préalablement mesurées.

Si la capacité et la conductance du transistor sont mesurées lors de l'étape de mesure, les étapes ultérieures de calcul des valeurs théoriques et de détermination des valeurs réelles des densités de défauts peuvent être réalisées en faisant appel à la capacité et la conductance du transistor, ou bien en ne faisant appel qu'à l'une ou l'autre de ces caractéristiques.

Par contre, si l'une seulement de la capacité ou de la conductance du transistor est mesurée lors de l'étape de mesure, les étapes ultérieures de calcul des valeurs théoriques et de détermination des valeurs réelles des densités de défauts peuvent alors être réalisées pour la caractéristique qui a été mesurée, à savoir la capacité ou la conductance. Toutefois, rien ne s'oppose à ce qu'un calcul des valeurs théoriques de la capacité et de la conductance soit réalisé, bien que seule l'une des caractéristiques parmi la capacité ou la conductance soit utilisée lors de la détermination des valeurs réelles des densités de défauts.

Le procédé selon l'invention repose donc sur des mesures de capacité et/ou de conductance du transistor FDSOI tout en utilisant le couplage électrostatique existant entre les interfaces avant et arrière du transistor, l'interface avant correspondant à l'interface entre le diélectrique de grille du transistor et le semi-conducteur destiné à former le canal du transistor, et l'interface arrière correspondant à l'interface entre le semi-conducteur destiné à former le canal du transistor et le diélectrique enterré du transistor.

Le procédé selon l'invention propose, par l'intermédiaire des mesures réalisées, de décorréler la réponse électrique des défauts de l'interface avant de celle des défauts de l'interface arrière, et d'utiliser une modélisation électrique du transistor permettant de retrouver les valeurs réelles des densités de défauts en comparant les résultats obtenus par la mesure et par la modélisation du transistor.

Ainsi, l'invention permet notamment d'évaluer de manière non destructrice les performances d'un transistor FDSOI existant.

Les valeurs théoriques de la capacité et/ou de la conductance d'un transistor modélisé par un circuit électrique équivalent au transistor FDSOI peuvent être calculées notamment en fonction des valeurs expérimentales des tensions $V_{FG}$ et $V_{BG}$ appliquées au transistor modélisé.

La tension $V_{FG}$ peut comporter une composante continue dont la valeur peut être comprise entre environ -2 V et 2 V et une composante alternative sinusoïdale dont la fréquence peut être comprise entre environ 10 kHz et 100 kHz et dont l'amplitude peut être comprise entre environ 30 mV et 40 mV.

La tension $V_{BG}$ peut être une tension continue dont la valeur peut être comprise entre environ 15 V et 30 V lorsque le transistor FDSOI est du type NMOS ou comprise entre environ -15 V et -30 V lorsque le transistor FDSOI est du type PMOS.

La capacité et/ou la conductance du transistor FDSOI peuvent être mesurées par un analyseur d'impédance.

Le circuit électrique équivalent au transistor FDSOI peut comporter une première capacité reliée électriquement en série avec un ensemble de composants reliés électriquement en parallèle les uns aux autres, ledit ensemble de composants pouvant comporter quatre capacités, pouvant correspondre à des capacités d'inversion dans le semi-conducteur destiné à former le canal du transistor modélisé du côté desdites interfaces du transistor modélisé et à des capacités des défauts auxdites interfaces du transistor modélisé, et deux conductances, pouvant correspondre à des conductances des défauts auxdites interfaces du transistor modélisé.

Les valeurs théoriques calculées de la capacité et/ou de la conductance peuvent être obtenues par la mise en oeuvre des étapes suivantes :

- calcul des valeurs théoriques de concentrations d'électrons $n_{S1}$ et $n_{S2}$ aux interfaces du transistor modélisé,
- calcul des valeurs théoriques de temps de vie caractéristiques des défauts $\tau_1$ et $\tau_2$ aux interfaces du transistor modélisé tel que :

$$\tau_{1,2} = \sigma_{1,2} \cdot v_{th} \cdot n_{S1,2}$$

- calcul des valeurs théoriques de capacités $C_{it1}$ et $C_{it2}$ aux interfaces du transistor modélisé pour les différentes valeurs théoriques choisies de $D_{it1}$ et $D_{it2}$ tel que :

$$C_{it1,2} = e.D_{it1,2} \frac{\arctan(\omega\tau_{1,2})}{\omega\tau_{1,2}}$$

- calcul des valeurs théoriques de conductances $G_{it1}$ et $G_{it2}$ aux interfaces du transistor modélisé pour les différentes valeurs théoriques choisies de $D_{it1}$ et $D_{it2}$ tel que :

$$G_{it1,2} = e.D_{it1,2} \frac{\ln(1 + (\omega\tau_{1,2})^2)}{2\omega\tau_{1,2}}$$

- calcul des valeurs théoriques de charges d'inversion $Q_{inv1}$ et $Q_{inv2}$ dans le semi-conducteur destiné à former le canal du transistor modélisé respectivement du côté de chacune des interfaces du transistor modélisé tel que :

$$Q_{inv1} = -e \int_0^{TSi/2} n(x)dx \quad \text{et} \quad Q_{inv2} = -e \int_{TSi/2}^{TSi} n(x)dx$$

- calcul des valeurs théoriques de potentiels électriques $\Psi_{S1}$ et $\Psi_{S2}$ dans le semi-conducteur destiné à former le canal du transistor modélisé respectivement du côté de chacune des interfaces du transistor modélisé,
- calcul des valeurs théoriques de capacités d'inversion $C_{inv1}$ et $C_{inv2}$ dans le semi-conducteur destiné à former le canal du transistor modélisé respectivement du côté de chacune des interfaces du transistor modélisé tel que :

$$C_{inv1,2} = \frac{dQ_{inv1,2}}{d\Psi_{S1,2}}$$

- calcul de la valeur théorique de l'admittance $Y_m$ du transistor modélisé tel que :

$$Y_m = \left[ (j\omega C_{ox})^{-1} + (j\omega(C_{inv1} + C_{inv2} + C_{it1} + C_{it2}) + G_{it1} + G_{it2})^{-1} \right]^{-1} = G_m + j\omega C_m$$

avec :

$\sigma_{1,2}$ : sections efficaces de capture aux interfaces du transistor modélisé ;
$v_{th}$ : vitesse thermique des porteurs de charges ;
$\omega$ : pulsation d'une composante alternative sinusoïdale de la tension $V_{FG}$ appliquée au transistor modélisé ;
$n(x)$ : concentration d'électrons à la profondeur x dans le semi-conducteur destiné à former le canal du transistor modélisé ;
$C_{ox}$ : capacité du diélectrique de grille du transistor modélisé ;
$C_m$ : capacité du transistor modélisé ;
$G_m$ : conductance du transistor modélisé ;
e : charge élémentaire ;
$T_{Si}$ : épaisseur du semi-conducteur destiné à former le canal du transistor.

Les valeurs théoriques des concentrations d'électrons $n_{S1}$ et $n_{S2}$ et des potentiels électriques $\Psi_{S1}$ et $\Psi_{S2}$ aux interfaces du transistor modélisé peuvent être calculées par un logiciel de type solveur Poisson Schrödinger à partir des valeurs de l'épaisseur du semi-conducteur destiné à former le canal du transistor modélisé, du dopage dudit semi-conducteur, de l'épaisseur d'oxyde équivalente de $SiO_2$ EOT du transistor modélisé, et de la tension $V_{BG}$.

La comparaison entre la conductance mesurée du transistor FDSOI et la conductance théorique calculée du transistor modélisé peut être réalisée en traçant et en superposant des courbes de ces conductances en fonction de la tension $V_{FG}$, puis en déterminant les valeurs théoriques choisies des densités de défauts $D_{it1}$, $D_{it2}$ aux interfaces du transistor modélisé pour lesquelles la courbe de la conductance théorique calculée comporte deux pics sensiblement superposés à deux pics de la courbe de la conductance mesurée.

La comparaison entre la capacité mesurée du transistor FDSOI et la capacité théorique calculée du transistor modélisé peut être réalisée en traçant et en superposant des courbes de ces capacités en fonction de la tension $V_{FG}$, puis en déterminant les valeurs théoriques choisies des densités de défauts $D_{it1}$, $D_{it2}$ aux interfaces du transistor modélisé pour lesquelles la courbe de la capacité théorique calculée comporte deux points d'inflexion sensiblement superposés à deux points d'inflexion de la courbe de la capacité mesurée.

L'invention concerne également un dispositif d'évaluation des performances électriques d'un transistor FDSOI, comportant des moyens de mise en oeuvre d'un procédé d'évaluation des performances électriques d'un transistor FDSOI tel que décrit ci-dessus.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente un transistor de type FDSOI,

- la figure 2 représente la caractéristique G(Vg) d'un transistor FDSOI pour une tension de substrat nulle,
- les figures 3 et 4 représentent respectivement les caractéristiques $C(V_{FG})$ et $G(V_{FG})$ d'un transistor FDSOI pour différentes valeurs de tension $V_{BG}$, obtenues lors de la mise en oeuvre d'un procédé d'évaluation des performances électriques de ce transistor, objet de la présente invention,
- la figure 5 représente des circuits électriques équivalents d'un transistor FDSOI prenant en compte ou non les défauts d'interfaces du transistor,
- les figures 6 et 7 représentent les caractéristiques $C(V_{FG})$ et $G(V_{FG})$ du transistor simulé superposées aux caractéristiques $C(V_{FG})$ et $G(V_{FG})$ mesurées du transistor lors de la mise en oeuvre d'un procédé d'évaluation des performances électriques de ce transistor, objet de la présente invention,
- la figure 8 représente un dispositif d'évaluation des performances électriques d'un transistor FDSOI, également objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

Dans le cas d'un transistor MOS de type bulk, c'est-à-dire réalisé sur un substrat massif de semi-conducteur, il est possible d'extraire la densité de défauts à l'interface avant, c'est-à-dire à l'interface entre le diélectrique de grille et la portion de semi-conducteur formant le canal, en utilisant les caractéristiques C(Vg) (capacité du transistor en fonction de la tension Vg appliquée sur la grille) et G(Vg) (conductance du transistor en fonction de la tension Vg appliquée sur la grille). En effet, en traçant la caractéristique G(Vg), un pic en régime d'inversion faible apparaît, ce pic étant proportionnel à la densité de défauts à l'interface avant du transistor. Dans le cas d'un transistor FDSOI, ce pic apparaît également sur la caractéristique G(Vg) de ce transistor. Toutefois, ce pic est proportionnel au cumul des défauts aux interfaces avant et arrière car la caractéristique G(Vg) est reliée directement à la densité d'électrons aux interfaces avant et arrière.

La figure 2 représente la caractéristique G(Vg) d'un transistor FDSOI, par exemple le transistor 1 représenté sur la figure 1. Cette caractéristique représente la valeur de la conductance du transistor 1, en S/m$^2$, en fonction de la tension Vg appliquée sur la grille 15 du transistor 1, en Volt, pour une tension de face arrière $V_{BG}$ (tension appliquée sur le substrat 3 du transistor 1) nulle. On voit sur la figure 2 que le pic apparaît pour une tension Vg égale à environ 0,1 V.

On voit donc qu'il n'est pas possible d'évaluer, à partir de la courbe tracée sur la figure 2, chacune des densités de défauts des interfaces du transistor FDSOI 1.

On détaille maintenant un procédé d'évaluation des performances électriques du transistor FDSOI 1 permettant de caractériser les défauts présents à l'interface entre le diélectrique de grille 13 du transistor 1 et le semi-conducteur 7 destiné à former le canal du transistor 1 (interface avant) et à l'interface entre le semi-conducteur 7 et le diélectrique enterré 5 du transistor 1 (interface arrière).

Ce procédé comporte deux phases .

- une première phase de décorrélation de la réponse électrique des défauts de l'interface avant du transistor 1 et de celle des défauts de l'interface arrière du transistor 1,
- une seconde phase de modélisation électrique du transistor 1 qui permettra ensuite, en comparant les précédentes mesures et les valeurs théoriques calculées de la capacité et/ou de la conductance du transistor modélisé pour différentes valeurs choisies des densités de défauts, d'évaluer les valeurs réelles des densités de défauts des interfaces avant et arrière du transistor FDSOI 1 dont les performances sont évaluées.

La première phase de décorrélation est réalisée en mesurant la capacité et la conductance du transistor 1 en fonction de la valeur d'une tension $V_{FG}$ appliquée sur la grille 15, avec une tension $V_{BG}$ appliquée sur la face arrière du transistor 1, c'est-à-dire sur le substrat 3, qui est supérieure à 0 lorsque le transistor 1 est de type NMOS, et qui est inférieure à 0 lorsque le transistor 1 est du type PMOS. Cela correspond physiquement dans le transistor 1 à séparer l'inversion du canal au niveau des interfaces avant et arrière.

Ces mesures sont réalisées en reliant électriquement la source 9 au drain 11, en appliquant la tension $V_{FG}$ entre la grille 15 et la source 9, et en appliquant la tension $V_{BG}$ sur le substrat 3 par l'intermédiaire d'une source de tension extérieure. Les mesures de la capacité et de la conductance sont réalisées avec un analyseur d'impédance, par exemple du type Agilent HP4184 ou équivalent, dont l'entrée High est reliée à la grille 15 et l'entrée Low à la source 9 du transistor 1. La tension $V_{FG}$ comprend une composante continue dont on fait varier la valeur, par exemple entre environ -2 V et +2 V, pour réaliser les mesures de la capacité et de la conductance du transistor 1, ainsi qu'une composante alternative d'amplitude comprise entre environ 30 mV et 40 mV et de fréquence par exemple comprise entre environ 10 kHz et 100 kHz, et par exemple fixée à 100 kHz.

Dans l'exemple décrit ici, les mesures de la capacité et de la conductance du transistor FDSOI 1, qui est par exemple de type NMOS, sont réalisées pour trois valeurs différentes de tension $V_{BG}$ correspondant à un champ électrique $E_{ox} = V_{BG}/T_{ox}$ dans le diélectrique enterré 5 compris entre environ 1,5 et 2 MV/cm, $T_{ox}$ étant l'épaisseur du diélectrique enterré 5 qui est ici égale à environ 145 nm. Les mesures sont donc réalisées pour $V_{BG}$ = 10 V, 20 V et 30 V. De plus, pour des raisons d'illustration, ces mesures sont également réalisées pour $V_{BG}$ = 0 V. Dans le cas d'un transistor de type PMOS, les mesures pourraient être réalisées pour $V_{BG}$ = - 10 V, -20 V et -30 V.

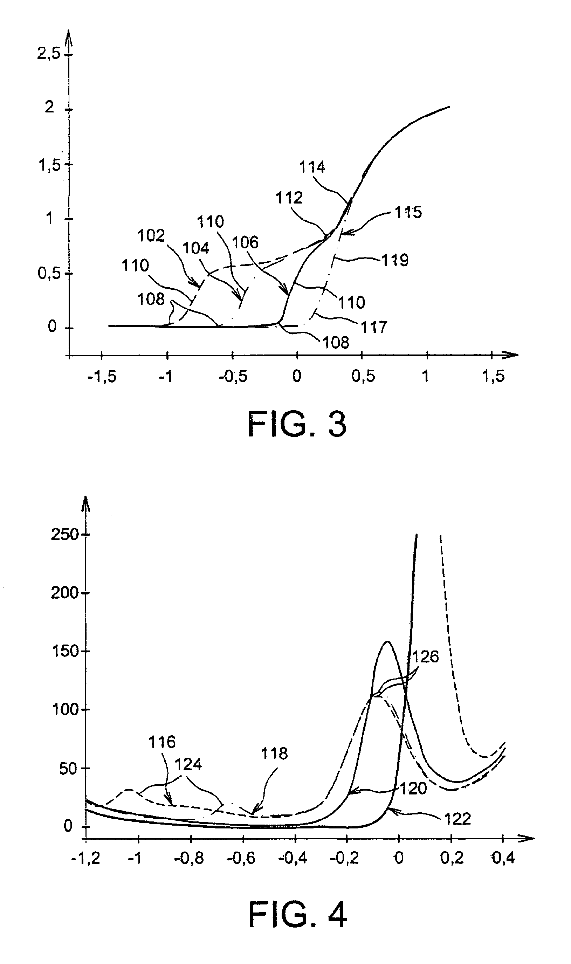

Sur la figure 3, les courbes 102, 104 et 106 représentent les caractéristiques $C(V_{FG})$ (en $\mu F/cm^2$, $V_{FG}$ étant exprimé en volts) respectivement pour une tension $V_{BG}$ égale à 30 V, 20 V et 10 V. On voit que chacune de ces courbes se compose d'un premier point d'inflexion 108 suivi d'une première pente 110 correspondant à l'inversion apparaissant au niveau de l'interface arrière du transistor FDSOI 1. Cette première pente 110 est suivie par un second point d'inflexion 112 lui-même suivi d'une seconde pente 114 correspondant à l'inversion apparaissant au niveau de l'interface avant du transistor FDSOI 1. Pour ces trois courbes, on voit qu'une phase de transition entre ces deux pentes correspond à une capacité égale à environ 0, 6 $\mu F/cm^2$.

Par comparaison, la courbe 115 représente la caractéristique $C(V_{FG})$ pour une tension $V_{BG}$ = 0. On voit que cette courbe ne comporte qu'un seul point d'inflexion 117 et qu'une seule pente 119 correspondant à l'inversion apparaissant simultanément aux interfaces avant et arrière du transistor FDSOI 1.

Sur la figure 4, les courbes 116, 118, 120 et 122 représentent les caractéristiques $G(V_{FG})$ (en $S/m^2$, avec $V_{FG}$ en Volt) respectivement pour une tension $V_{BG}$ égale à 30 V, 20 V, 10 V et 0 V. On voit que les courbes 116 et 118 comportent chacune deux pics 124 et 126 distincts apparaissant pendant l'inversion faible au niveau des interfaces arrière et avant respectivement, ces deux pics étant caractéristiques des défauts présents aux interfaces arrière et avant du transistor FDSOI 1. Pour $V_{BG}$ = 30 V, le premier pic 124 apparait à $V_{FG}$ égal à environ -1,05 V et le second pic 126 apparait à $V_{FG}$ égal à environ -0,1 V. Pour $V_{BG}$ = 20 V, le premier pic 124 apparait à $V_{FG}$ égal à environ -0,65 V et le second pic 126 apparait à $V_{FG}$ égal à environ -0,1 V. Par contre, pour les courbes 120 et 122, un seul pic apparait.

On voit qu'une tension $V_{BG}$ égale à 0 V ou 10 V n'est pas adaptée pour pouvoir évaluer individuellement les densités de défauts aux interfaces avant et arrière du transistor FDSOI 1 à partir de la conductance du transistor 1.

Ainsi, parmi les trois tensions $V_{BG}$ > 0 pour lesquelles les caractéristiques $C(V_{FG})$ et $G(V_{FG})$ ont été tracées (10, 20 et 30 volts), on conserve une seule de ces tensions. Cette tension est choisie afin qu'elle fasse apparaître, sur la caractéristique $G(V_{FG})$, 2 pics de conductance distincts qui correspondent aux réponses électriques des défauts aux interfaces avant et arrière du transistor 1. Pour l'exemple décrit précédemment en liaison avec la figure 4, la tension $V_{BG}$ choisie peut être indifféremment 20 volts ou 30 volts car pour ces deux tensions, les deux pics apparaissent clairement.

Ainsi, l'étape de mesure de la capacité et de la conductance du transistor FDSOI 1 peut donc être mise en oeuvre soit en choisissant dès le début une valeur $V_{BG}$ > 0 adaptée, c'est-à-dire qui fasse apparaître deux pics sur la caractéristique $G(V_{FG})$, soit en réalisant ces mesures pour différentes valeurs de $V_{BG}$ > 0, puis en choisissant parmi celles-ci la valeur de $V_{BG}$ la plus adaptée, par exemple celle faisant apparaître le plus distinctement les deux pics sur la caractéristique $G(V_{FG})$.

Les mesures de la capacité $C(V_{FG})$ et de la conductance $G(V_{FG})$ du transistor FDSOI 1 réalisées permettent donc d'obtenir l'admittance Y du transistor FDSOI 1 :

$$Y = G(V_{FG}) + j\omega C(V_{FG}) \qquad\qquad (1)$$

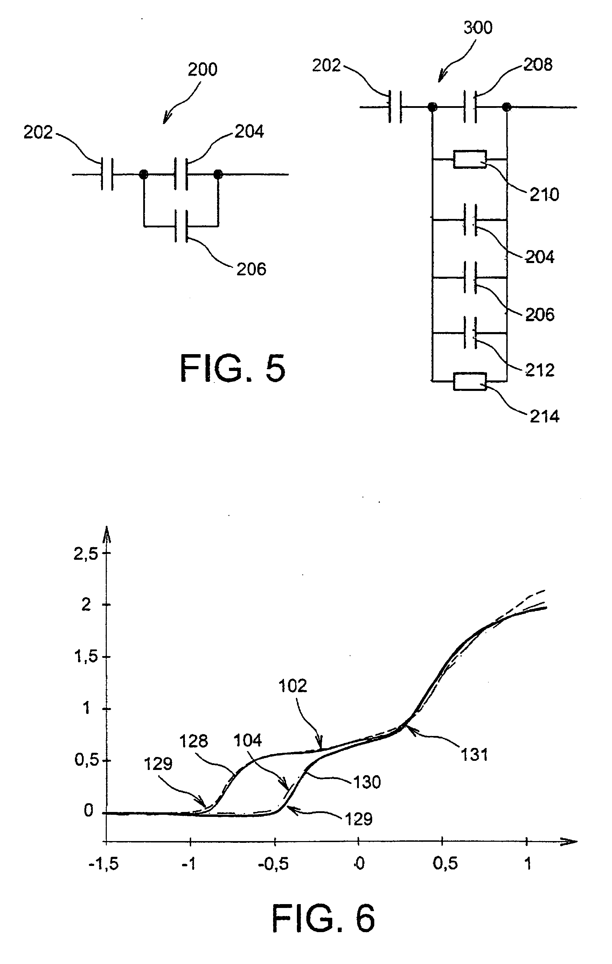

La seconde phase du procédé consiste à simuler les caractéristiques $C(V_{FG})$ et $G(V_{FG})$ obtenues à la tension $V_{BG}$ choisie à partir d'un circuit électrique équivalent au transistor FDSOI 1 pour différentes valeurs théoriques choisies de densités de défauts aux interfaces avant et arrière du transistor simulé, afin de déterminer ensuite les valeurs réelles des densités de défauts aux interfaces avant et arrière du transistor FDSOI 1. Le circuit électrique équivalent établi pour modéliser la réponse des défauts d'interfaces ainsi que l'admittance équivalente associée (l'admittance étant composée de la capacité et de la conductance) est représentée sur la figure 5.

Sur cette figure 5, le circuit 200 correspond au circuit électrique équivalent du transistor FDSOI sans considérer les défauts d'interfaces avant et arrière du transistor. La capacité 202, appelée $C_{ox}$, représente la capacité formée par le diélectrique de grille du transistor. Cette capacité 202 est reliée électriquement en série avec deux autres capacités 204 et 206 qui sont reliées électriquement entre elles en parallèle et qui représentent les capacités d'inversion $C_{inv1}$ et $C_{inv2}$ dans le semi-conducteur destiné à former le canal du transistor modélisé respectivement du côté de chacune des interfaces avant et arrière du transistor modélisé.

L'admittance $Y_a$ du circuit 200 est égale à :

$$Y_a = \left[ \left( j\omega C_{ox} \right)^{-1} + \left( j\omega (C_{inv1} + C_{inv2}) \right)^{-1} \right]^{-1} \qquad (2)$$

Le circuit 300 correspond au circuit électrique équivalent du transistor FDSOI en considérant les défauts d'interfaces avant et arrière.

C'est ce circuit électrique équivalent 300 qui est considéré dans le procédé d'évaluation des performances électriques du transistor FDSOI 1. Les défauts de l'interface avant sont modélisés par une capacité 208, appelée $C_{it1}$, reliée en parallèle à une conductance 210 appelée $G_{it1}$ et qui est elle-même reliée en parallèle à la capacité 204 $C_{inv1}$. Les défauts de l'interface arrière sont modélisés par une capacité 212, appelée $C_{it2}$, reliée en parallèle à une conductance 214 appelée $G_{it2}$.

La capacité 212 $C_{it2}$ est reliée en parallèle à la capacité 206 $C_{inv2}$.

En effet, la charge totale $Q_{tot}$ du circuit 300 correspond à la somme des charges d'inversion à l'interface avant $Q_{inv1}$ et à l'interface arrière $Q_{inv2}$, des charges de la portion de silicium désertée $Q_{dep}$ et des charges induites par les défauts de l'interface avant $Q_{it1}$ et de l'interface arrière $Q_{it2}$ :

$$Q_{tot} = Q_{it1} + Q_{inv1} + Q_{dep} + Q_{inv2} + Q_{it2}$$

En dérivant $Q_{tot}$ par rapport au potentiel de surface avant $\Psi_{S1}$, on en déduit la capacité totale :

$$C_{tot} = \frac{dQ_{tot}}{d\Psi_{S1}} = C_{it1} + C_{inv1} + C_{inv2} + C_{it2}$$

On obtient donc la somme de 4 capacités (la portion de silicium étant complètement désertée, on a donc

$$\frac{dQ_{dep}}{d\Psi_{S1}} = 0 \; ) \; ,$$

ce qui équivaut électriquement à 4 capacités reliées en parallèle. Pour modéliser les pics de conductance, chacune des capacités représentant la réponse des défauts d'interfaces ($C_{it1}$ et $C_{it2}$) est associée à une conductance, appelée respectivement $G_{it1}$ et $G_{it2}$.

L'admittance $Y_m$ du circuit 300 est donc égale à :

$$Y_m = \left[ \left( j\omega C_{ox} \right)^{-1} + \left( j\omega (C_{inv1} + C_{inv2} + C_{it1} + C_{it2}) + G_{it1} + G_{it2} \right)^{-1} \right]^{-1} \qquad (3)$$

En calculant les valeurs théoriques des différents éléments de l'admittance $Y_m$, il sera donc possible de calculer les valeurs théoriques de la capacité $C_m$ et/ou de la conductance $G_m$ du transistor modélisé correspondant au circuit électrique équivalent 300 car :

$$Y_m = G_m + j\omega C_m \qquad (4)$$

Ces valeurs sont calculées en utilisant un logiciel de type solveur de Poisson Schrödinger, par exemple le logiciel SCHRED, et un logiciel de calculs mathématiques, par exemple le logiciel MATHCAD®.

Les paramètres d'entrée du logiciel de type solveur de Poisson Schrödinger sont : l'épaisseur $T_{Si}$ de la portion de silicium formant le canal du transistor modélisé, par exemple égale à 15 nm, et son dopage Na, par exemple égal à $10^{15}/cm^3$, l'épaisseur d'oxyde équivalente de $SiO_2$ EOT du transistor modélisé, par exemple compris entre environ 1 nm et 2 nm (le calcul de l'EOT d'un transistor étant décrit par exemple décrit dans le document EP 1 591 558), et la valeur de la tension $V_{BG}$ choisie lors des mesures sur le transistor FDSOI 1.

A partir de ces paramètres d'entrée, le logiciel peut calculer alors la concentration d'électrons n(x) et le potentiel $\Psi(x)$ au niveau de la profondeur x dans la portion de silicium destinée à former le canal, cette profondeur étant comprise entre 0 et $T_{Si}$. Il est donc possible de calculer les potentiels de surface à l'interface avant $\Psi_{S1} = \Psi(0)$ et à l'interface arrière $\Psi_{S2} = \Psi(T_{Si})$, ainsi que les concentrations d'électrons à ces interfaces : $n_{S1} = n(0)$ et $n_{S2} = n(T_{Si})$.

En considérant les profils des défauts d'interface constants dans le gap du silicium, les deux capacités $C_{it1,2}$ et les deux conductances $G_{it1,2}$ aux interfaces du transistor modélisé s'écrivent :

$$C_{it1,2} = e.D_{it1,2}\, \frac{\arctan(\omega\tau_{1,2})}{\omega\tau_{1,2}} \qquad (5)$$

$$G_{it1,2} = e.D_{it1,2}\, \frac{\ln(1+(\omega\tau_{1,2})^2)}{2\omega\tau_{1,2}} \qquad (6)$$

avec $\omega$ : la pulsation de la composante alternative sinusoïdale de la tension $V_{FG}$ appliquée au transistor modélisé (égale à $2\pi.10^5$ pour une fréquence de 100 kHz) ;
$\tau_{1,2}$ : temps de vie caractéristiques des défauts $\tau_1$ et $\tau_2$ aux interfaces avant et arrière du transistor modélisé ;
e : charge électrique.

Or, les temps de vie $\tau_{1,2}$ peuvent se calculer selon l'équation :

$$\tau_{1,2} = \sigma_{1,2}.v_{th}.n_{S1,2} \qquad (7)$$

où $\sigma_{1,2}$ est la section efficace de capture aux interfaces du transistor modélisé (par exemple comprises entre environ $10^{-14}\ cm^2$ et $10^{-18}\ cm^2$) et $V_{th}$ la vitesse thermique des porteurs de charges (par exemple égale à $10^5\ cm^{-2}$).

Etant donné que les paramètres $\Psi_{S1}$, $\Psi_{S2}$, $n_{S1}$ et $n_{S2}$ ont été précédemment calculés, il est possible de calculer les paramètres $\tau_1$ et $\tau_2$ et donc d'en déduire les valeurs de $C_{it1,2}$ et $G_{it1,2}$ en choisissant différentes valeurs théoriques de $D_{it1,2}$.

Parallèlement à cela, et à partir de la concentration d'électrons n(x) précédemment calculée, on calcule les charges d'inversion en faces avant $Q_{inv1}$ et arrière $Q_{inv2}$ en intégrant la charge -e.n(x) sur la moitié de la portion de silicium formant le canal, c'est-à-dire entre x=0 et x=$T_{Si}/2$ pour $Q_{inv1}$ et entre x=$T_{Si}/2$ et x=$T_{Si}$ pout $Q_{inv2}$ :

$$Q_{inv1} = -e\int_{0}^{TSi/2} n(x)dx \quad \text{et} \quad Q_{inv2} = -e\int_{TSi/2}^{TSi} n(x)dx \qquad (8)$$

En dérivant ces deux paramètres par rapport au potentiel de surface avant $\Psi_{S1}$ et arrière $\Psi_{S2}$, on obtient les valeurs des deux capacités d'inversion $C_{inv1}$ et $C_{inv2}$ :

$$C_{inv1,2} = \frac{dQ_{inv1,2}}{d\Psi_{S1,2}} \qquad (9)$$

A partir des éléments calculés précédemment, il est donc possible de calculer l'admittance $Y_m$, et de donc de calculer la capacité $C_m$ et la conductance $G_m$ du transistor simulé pour les différentes valeurs de $D_{it1,2}$ précédemment choisies.

Sur la figure 6, les courbes 128 et 130 représentent les caractéristiques $C(V_{FG})$ du transistor simulé respectivement pour $V_{BG}$ = 30 V et 20 V et pour les valeurs $D_{it1}$ = 3.10$^{10}$ cm$^{-2}$eV$^{-1}$ et $D_{it2}$ = 5.10$^{11}$ cm$^{-2}$eV$^{-1}$

Sur cette figure, les courbes 128 et 130 sont superposées aux courbes 102 et 104 correspondant aux caractéristiques C($V_{FG}$) mesurées pour $V_{BG}$ = 30V et 20 V (voir figure 3). On voit que les courbes 102 et 128 comportent bien deux points d'inflexion 129 et 131 qui se superposent, de même que pour les courbes 104 et 130, ce qui signifie que ces valeurs théoriques choisies de $D_{it1}$ et $D_{it2}$ correspondent bien aux valeurs réelles de $D_{it1}$ et $D_{it2}$ du transistor FDSOI 1.

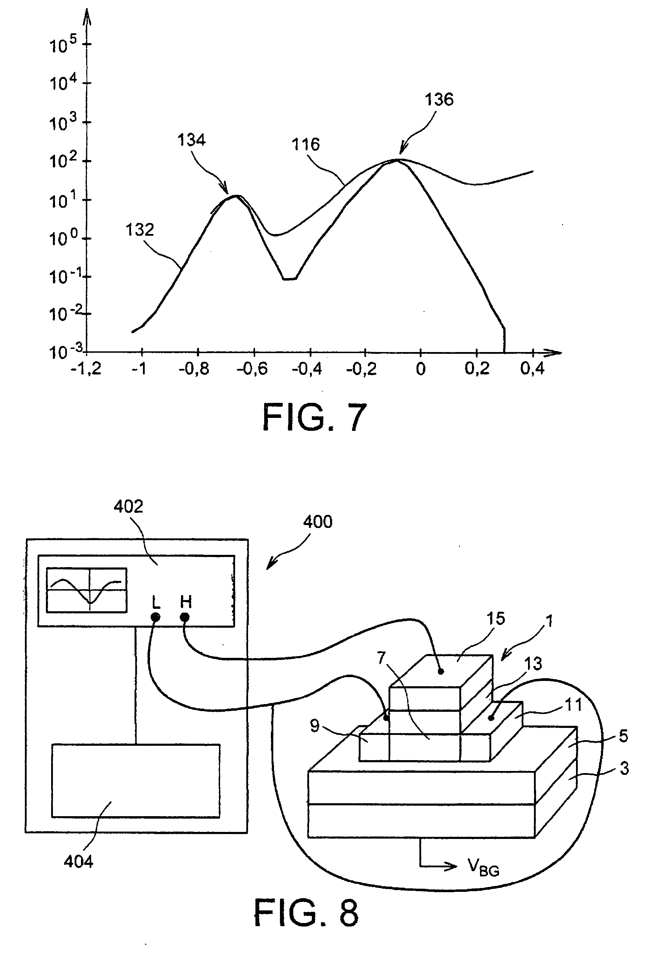

Sur la figure 7, la courbe 132 représente la caractéristique G($V_{FG}$) du transistor simulé pour $V_{BG}$ = 30 V et pour les valeurs $D_{it1}$ = 3.10$^{10}$ cm$^{-2}$eV$^{-1}$ et $D_{it2}$ = 5.10$^{11}$ cm$^{-2}$eV$^{-1}$. Là encore, la courbe 132 est superposée à la courbe 116 correspondant à la caractéristique G($V_{FG}$) mesurée pour $V_{BG}$ = 30 V (voir figure 4). Les courbes 132 et 116 comportent bien deux pics 134 et 136 qui se superposent, ce qui signifie que ces valeurs théoriques choisies de $D_{it1}$ et $D_{it2}$ correspondent bien aux valeurs réelles de $D_{it1}$ et $D_{it2}$ du transistor FDSOI 1.

Le choix des caractéristiques C($V_{FG}$) et G($V_{FG}$) du transistor simulé dont les pics ou les points d'inflexion se superposent le mieux avec ceux des caractéristiques C($V_{FG}$) et G($V_{FG}$) mesurées, qui correspond donc à la détermination des valeurs réelles de $D_{it1}$ et $D_{it2}$, peut être réalisé automatiquement à l'aide d'un logiciel de calcul.

Le procédé d'évaluation des performances électriques du transistor FDSOI 1 a été précédemment décrit en utilisant la capacité et la conductance du transistor FDSOI 1 et du transistor simulé pour retrouver les valeurs réelles de $D_{it1}$ et $D_{it2}$ du transistor FDSOI 1. Toutefois, il est tout à fait possible de n'utiliser que la conductance, ou que la capacité, pour retrouver les valeurs réelles de $D_{it1}$ et $D_{it2}$ du transistor FDSOI 1. De plus, il est également possible de réaliser plusieurs fois ce procédé d'évaluation en utilisant à chaque fois une fréquence différente pour la composante alternative de la tension $V_{FG}$ si l'on souhaite confirmer les résultats obtenus.

A partir des valeurs obtenues de $D_{it1}$ et $D_{it2}$, il est donc possible de déterminer le niveau des performances du transistor FDSOI 1. On pourra notamment considérer qu'une densité de défauts inférieure à environ 1.10$^{11}$ cm$^{-2}$eV$^{-1}$ est une valeur indiquant que l'interface est de bonne qualité (cas de l'interface arrière du transistor FDSOI 1 : $D_{it1}$ = 3.10$^{10}$ cm$^{-2}$eV$^{-1}$) et qu'une densité de défauts supérieure à environ 1.10$^{11}$ cm$^{-2}$eV$^{-1}$ indique que l'interface est dégradé (cas de l'interface avant du transistor FDSOI 1 : $D_{it2}$ = 5.10$^{11}$ cm$^{-2}$eV$^{-1}$).

Le procédé précédemment décrit peut être mis en oeuvre par un dispositif 400 représenté sur la figure 8 comportant un analyseur d'impédance 402 ainsi que des moyens de calcul 404 réalisant les calculs relatifs à la modélisation du transistor FDSOI 1. Les moyens de calcul 404 peuvent notamment être un ordinateur sur lequel les logiciels précédemment décrits peuvent être exécutés.

## Revendications

**1.** Procédé d'évaluation des performances électriques d'un transistor FDSOI (1), **caractérisé en ce qu'**il comporte les étapes de :

- mesure de la capacité (102, 104, 106) et/ou de la conductance (116, 118, 120) du transistor FDSOI (1), en appliquant une tension $V_{BG}$ > 0 sur un substrat (3) à base de semi-conducteur du transistor FDSOI (1) lorsque le transistor FDSOI (1) est du type NMOS ou une tension $V_{BG}$ < 0 sur le substrat (3) à base de semi-conducteur du transistor FDSOI (1) lorsque le transistor FDSOI (1) est du type PMOS, en fonction d'une tension $V_{FG}$ appliquée entre la grille (15) et les régions de source (9) et drain (11) du transistor FDSOI (1),
- calcul des valeurs théoriques de la capacité (128, 130) et/ou de la conductance (132) d'un transistor modélisé par un circuit électrique équivalent (300) au transistor FDSOI (1), en fonction des valeurs des tensions $V_{FG}$ et $V_{BG}$ appliquées au transistor modélisé et pour différentes valeurs théoriques choisies de densités de défauts $D_{it1}$, $D_{it2}$ respectivement à une interface entre un diélectrique de grille du transistor modélisé et un semi-conducteur destiné à former le canal du transistor modélisé et une interface entre le semi-conducteur destiné à former le canal du transistor modélisé et un diélectrique enterré du transistor modélisé,
- détermination des valeurs réelles des densités de défauts $D_{it1}$, $D_{it2}$ aux interfaces correspondantes du transistor FDSOI (1) par une comparaison entre les valeurs mesurées de la capacité (102, 104, 106) et/ou de la conductance (116, 118, 120) du transistor FDSOI (1) et les valeurs théoriques calculées de la capacité (128, 130) et/ou de la conductance (132) du transistor modélisé pour les différentes valeurs théoriques choisies des densités de défauts $D_{it1}$, $D_{it2}$ aux interfaces du transistor modélisé, et dans lequel, lorsque la conductance (116, 118, 120) du transistor FDSOI (1) est mesurée, la valeur de la tension $V_{BG}$ est choisie telle qu'une courbe (116, 118, 120) représentant la conductance mesuré du transistor FDSOI (1) en fonction de la tension $V_{FG}$ comporte au moins deux pics (124, 126).

**2.** Procédé selon la revendication 1, dans lequel la tension $V_{FG}$ comporte une composante continue dont la valeur est comprise entre environ -2 V et 2 V et une composante alternative sinusoïdale dont la fréquence est comprise entre environ 10 kHz et 100 kHz.

3. Procédé selon l'une des revendications précédentes, dans lequel la tension $V_{BG}$ est une tension continue dont la valeur est comprise entre environ 15 V et 30 V lorsque le transistor FDSOI (1) est du type NMOS ou comprise entre environ -15 V et -30 V lorsque le transistor FDSOI (1) est du type PMOS.

4. Procédé selon l'une des revendications précédentes, dans lequel la capacité (102, 104, 106) et/ou la conductance (116, 118, 120) du transistor FDSOI (1) sont mesurées par un analyseur d'impédance.

5. Procédé selon l'une des revendications précédentes, dans lequel le circuit électrique équivalent (300) au transistor FDSOI (1) comporte une première capacité (202) reliée électriquement en série avec un ensemble de composants reliés électriquement en parallèle les uns aux autres, ledit ensemble de composants comportant quatre capacités (204, 206, 208, 212), correspondant à des capacités d'inversion dans le semi-conducteur destiné à former le canal du transistor modélisé du côté desdites interfaces du transistor modélisé et à des capacités des défauts auxdites interfaces du transistor modélisé, et deux conductances (210, 214), correspondant à des conductances des défauts auxdites interfaces du transistor modélisé.

6. Procédé selon l'une des revendications précédentes, dans lequel les valeurs théoriques calculées de la capacité (128, 130) et/ou de la conductance (132) sont obtenues par la mise en oeuvre des étapes suivantes :

- calcul des valeurs théoriques de concentrations d'électrons $n_{S1}$ et $n_{S2}$ aux interfaces du transistor modélisé,
- calcul des valeurs théoriques de temps de vie caractéristiques des défauts $\tau_1$ et $\tau_2$ aux interfaces du transistor modélisé tel que :

$$\tau_{1,2} = \sigma_{1,2}.v_{th}.n_{S1,2}$$

- calcul des valeurs théoriques de capacités $C_{it1}$, et $C_{it2}$ aux interfaces du transistor modélisé pour les différentes valeurs théoriques choisies de $D_{it1}$ et $D_{it2}$ tel que :

$$C_{it1,2} = e.D_{it1,2} \frac{\arctan(\omega\tau_{1,2})}{\omega\tau_{1,2}}$$

- calcul des valeurs théoriques de conductances $G_{it1}$ et $G_{it2}$ aux interfaces du transistor modélisé pour les différentes valeurs théoriques choisies de $D_{it1}$ et $D_{it2}$ tel que :

$$G_{it1,2} = e.D_{it1,2} \frac{\ln(1+(\omega\tau_{1,2})^2)}{2\omega\tau_{1,2}}$$

- calcul des valeurs théoriques de charges d'inversion $Q_{inv1}$ et $Q_{inv2}$ dans le semi-conducteur destiné à former le canal du transistor modélisé respectivement du côté de chacune des interfaces du transistor modélisé tel que :

$$Q_{inv1} = -e \int_0^{TSi/2} n(x)dx \quad \text{et} \quad Q_{inv2} = -e \int_{TSi/2}^{TSi} n(x)dx$$

- calcul des valeurs théoriques de potentiels électriques $\Psi_{S1}$ et $\Psi_{S2}$ dans le semi-conducteur destiné à former le canal du transistor modélisé respectivement du côté de chacune des interfaces du transistor modélisé,
- calcul des valeurs théoriques de capacités d'inversion $C_{inv1}$ et $C_{inv2}$ dans le semi-conducteur destiné à former le canal du transistor modélisé respectivement du côté de chacune des interfaces du transistor modélisé tel que :

$$C_{inv1,2} = \frac{dQ_{inv1,2}}{d\Psi_{S1,2}}$$

- calcul de la valeur théorique de l'admittance $Y_m$ du transistor modélisé tel que :

$$Y_m = \left[(j\omega C_{ox})^{-1} + \left(j\omega(C_{inv1} + C_{inv2} + C_{it1} + C_{it2}) + G_{it1} + G_{it2}\right)^{-1}\right]^{-1} = G_m + j\omega C_m$$

avec .

$\sigma_{1,2}$ : sections efficaces de capture aux interfaces du transistor modélisé ;

$v_{th}$ : vitesse thermique des porteurs de charges ;

$\omega$ : pulsation d'une composante alternative sinusoïdale de la tension $V_{FG}$ appliquée au transistor modélisé n(x) : concentration d'électrons à la profondeur x dans le semi-conducteur destiné à former le canal du transistor modélisé ;

$C_{ox}$ : capacité du diélectrique de grille du transistor modélisé ;

$C_m$ : capacité du transistor modélisé $G_m$ : conductance du transistor modélisé ; $T_{Si}$ : épaisseur du semi-conducteur destiné à former le canal du transistor.

7. Procédé selon la revendication 6, dans lequel les valeurs théoriques des concentrations d'électrons $n_{S1}$ et $n_{S2}$ et des potentiels électriques $\Psi_{S1}$ et $\Psi_{S2}$ aux interfaces du transistor modélisé sont calculées par un logiciel de type solveur Poisson Schrödinger à partir des valeurs de l'épaisseur du semi-conducteur destiné à former le canal du transistor modélisé, du dopage dudit semi-conducteur, de l'épaisseur d'oxyde équivalente de $SiO_2$ EOT du transistor modélisé, et de la tension $V_{BG}$.

8. Procédé selon l'une des revendications précédentes, dans lequel la comparaison entre la conductance mesurée (116, 118) du transistor FDSOI (1) et la conductance théorique calculée (132) du transistor modélisé est réalisée en traçant et en superposant des courbes de ces conductances en fonction de la tension $V_{FG}$, puis en déterminant les valeurs théoriques choisies des densités de défauts $D_{it1}$, $D_{it2}$ aux interfaces du transistor modélisé pour lesquelles la courbe de la conductance théorique calculée (132) comporte deux pics (134, 136) sensiblement superposés à deux pics de la courbe de la conductance mesurée (116).

9. Procédé selon l'une des revendications précédentes, dans lequel la comparaison entre la capacité mesurée (102, 104, 106) du transistor FDSOI (1) et la capacité théorique calculée (128, 130) du transistor modélisé est réalisée en traçant et en superposant des courbes de ces capacités en fonction de la tension $V_{FG}$, puis en déterminant les valeurs théoriques choisies des densités de défauts $D_{it1}$, $D_{it2}$ aux interfaces du transistor modélisé pour lesquelles la courbe de la capacité théorique (128, 130) calculée comporte deux points d'inflexion (129, 131) sensiblement superposés à deux points d'inflexion de la courbe de la capacité mesurée (102, 104).

10. Dispositif (400) d'évaluation des performances électriques d'un transistor FDSOI (1), comportant des moyens (402, 404) de mise en oeuvre d'un procédé d'évaluation des performances électriques d'un transistor FDSOI (1) selon l'une des revendications 1 à 9.

**Claims**

1. A method for evaluating the electric performances of an FDSOI transistor (1), **characterized in that** it comprises the steps of:

- measuring the capacitance (102, 104, 106) and/or the conductance (116, 118, 120) of the FDSOI transistor (1), by applying a voltage $V_{BG} > 0$ on a substrate (3) composed of semiconductor of the FDSOI transistor (1) when the FDSOI transistor (1) is of the NMOS type or a voltage $V_{BG} < 0$ on the substrate (3) composed of semiconductor of the FDSOI transistor (1) when the FDSOI transistor (1) is of the PMOS type, depending on a voltage $V_{FG}$ applied between the gate (15) and the source (9) and drain (11) regions of the FDSOI transistor (1),
- calculating the theoretical values of the capacitance (128, 130) and/or the conductance (132) of a transistor modeled by an electric circuit (300) equivalent to the FDSOI transistor (1), depending on the values of the voltages $V_{FG}$ and $V_{BG}$ applied to the modeled transistor and for different selected theoretical values of defect densities $D_{it1}$, $D_{it2}$ at an interface between a gate dielectric of the modeled transistor and a semiconductor intended to form the channel of the modeled transistor and an interface between the semiconductor intended to form the channel of the modeled transistor and a buried dielectric of the modeled transistor respectively,
- determining the real values of the defect densities $D_{it1}$, $D_{it2}$ at the corresponding interfaces of the FDSOI transistor (1) by a comparison between the measured values of the capacitance (102, 104, 106) and/or of the conductance (116, 118, 120) of the FDSOI transistor (1) and the calculated theoretical values of the capacitance (128, 130) and/or of the conductance (132) of the modeled transistor for the different selected theoretical values of the defect densities $D_{it1}$, $D_{it2}$ at the interfaces of the modeled transistor, and in which, when the conductance (116, 118, 120) of the FDSOI transistor (1) is measured, the value of the voltage $V_{BG}$ is selected such that a curve (116, 118, 120) illustrating the measured conductance of the FDSOI transistor (1) depending on the voltage $V_{FG}$ includes at least two peaks (124, 126).

2. The method according to claim 1, wherein the voltage $V_{FG}$ includes a DC component, the value of which is comprised between about -2 V and 2 V and an alternating sinusoidal component, the frequency of which is comprised between about 10 kHz and 100 kHz.

3. The method according to any of the preceding claims, wherein the voltage $V_{BG}$ is a DC voltage, the value of which is comprised between about 15 V and 30 V when the FDSOI transistor (1) is of the NMOS type or comprised between about -15 V and -30 V when the FDSOI transistor (1) is the PMOS type.

4. The method according to any of the preceding claims, wherein the capacitance (102, 104, 106) and/or the conductance (116, 118, 120) of the FDSOI transistor (1) are measured by an impedance analyzer.

5. The method according to any of the preceding claims, wherein the electric circuit (300) equivalent to the FDSOI transistor (1) includes a first capacitance (202) electrically connected in series with a set of components electrically connected in parallel with each other, said set of components including four capacitances (204, 206, 208, 212), corresponding to inversion capacitances in the semiconductor intended to form the channel of the modeled transistor on the side of said interfaces of the modeled transistor and to capacitances of the defects at said interfaces of the modeled transistor, and two conductances (210, 214), corresponding to conductances of the defects at said interfaces of the modeled transistor.

6. The method according to any of the preceding claims, wherein the calculated theoretical values of the capacitance (128, 130) and/or of the conductance (132) are obtained by applying the following steps:

   - calculating the theoretical values of electron concentrations $n_{S1}$ and $n_{S2}$ at the interfaces of the modeled transistor,
   - calculating the theoretical characteristic life-time values of the defects $\tau_1$ and $\tau_2$ at the interfaces of the modeled transistor such that:

$$\tau_{1,2} = \sigma_{1,2} . v_{th} . n_{S1,2}$$

   - calculating the theoretical values of capacitances $C_{it1}$ and $C_{it2}$ at the interfaces of the modeled transistor for the different selected theoretical values of $D_{it1}$ and $D_{it2}$ such that:

$$C_{it1,2} = e.D_{it1,2} \frac{\arctan(\omega\tau_{1,2})}{\omega\tau_{1,2}}$$

   - calculating the theoretical values of conductances $G_{it1}$ and $G_{it2}$ at the interfaces of the modeled transistor for the different selected theoretical values of $D_{it1}$ and $D_{it2}$ such that:

$$G_{it1,2} = e.D_{it1,2} \frac{\ln(1 + (\omega\tau_{1,2})^2)}{2\omega\tau_{1,2}}$$

- calculating the theoretical values of inversion charges $Q_{inv1}$ and $Q_{inv2}$ in the semiconductor intended to form the channel of the modeled transistor, respectively on the side of each of the interfaces of the modeled transistor so that:

$$Q_{inv1} = -e \int_0^{TSi/2} n(x)dx \quad \text{et} \quad Q_{inv2} = -e \int_{TSi/2}^{TSi} n(x)dx$$

- calculating the theoretical values of electric potentials $\Psi_{S1}$ and $\Psi_{S2}$ in the semiconductor intended to form the channel of the modeled transistor, respectively on the side of each of the interfaces of the modeled transistor,
- calculating the theoretical values of inversion capacitances $C_{inv1}$ and $C_{inv2}$ in the semiconductor intended to form the channel of the modeled transistor, respectively on the side of each of the interfaces of the modeled transistor such that:

$$C_{inv1,2} = \frac{dQ_{inv1,2}}{d\Psi_{S1,2}}$$

- calculating the theoretical value of the admittance $Y_m$ of the modeled transistor such that:

$$Y_m = \left[ \left(j\omega C_{ox}\right)^{-1} + \left(j\omega(C_{inv1} + C_{inv2} + C_{it1} + C_{it2}) + G_{it1} + G_{it2}\right)^{-1} \right]^{-1} = G_m + j\omega C_m$$

with:

$\sigma_{1,2}$: capture cross-sections at the interfaces of the modeled transistor;
$v_{th}$: thermal velocity of the charge carriers;
$\omega$: angular frequency of an alternating sinusoidal component of the voltage $V_{FG}$ applied to the modeled transistor;
$n(x)$: electron concentration at depth x in the semiconductor intended to form the channel of the modeled transistor;
$C_{ox}$: capacitance of the gate dielectric of the modeled transistor;
$C_m$: capacitance of the modeled transistor;
$G_m$: conductance of the modeled transistor;
$T_{Si}$: thickness of the semiconductor intended to form the channel of the transistor.

7. The method according to claim 6, wherein the theoretical values of the electron concentrations $n_{S1}$ and $n_{S2}$ and of the electric potentials $\Psi_{S1}$ and $\Psi_{S2}$ at the interfaces of the modeled transistor are calculated by a software of the Poisson Schrödinger solver type from values of the thickness of the semiconductor intended to form the channel of the modeled transistor, from the doping of said semiconductor, from the $SiO_2$ equivalent oxide thickness EOT of the modeled transistor, and from the voltage $V_{BG}$.

8. The method according to any of the preceding claims, wherein the comparison between the measured conductance (116, 118) of the FDSOI transistor (1) and the calculated theoretical conductance (132) of the modeled transistor is made by plotting and by superposing curves of these conductances depending on the voltage $V_{FG}$, and then by determining the selected theoretical values of the defects densities $D_{it1}$, $D_{it2}$ at the interfaces of the modeled transistor for which the curve of the calculated theoretical conductance (132) includes two peaks (134, 136) substantially superposed to two peaks of the curve of the measured conductance (116).

9. The method according to any of the preceding claims, wherein the comparison between the measured capacitance (102, 104, 106) of the FDSOI transistor (1) and the calculated theoretical capacitance (128, 130) of the modeled transistor is made by plotting and by superposing curves of these capacitances depending on the voltage $V_{FG}$, and then by determining the selected theoretical values of the defect densities $D_{it1}$, $D_{it2}$ at the interfaces of the modeled transistor for which the curve of the calculated theoretical capacitance (128, 130) includes two inflection points (129, 131) substantially superposed to two inflection points of the curve of the measured capacitance (102, 104).

10. A device (400) for evaluating the electric performances of an FDSOI transistor (1), including means (402, 404) for applying a method for evaluating the electric performances of an FDSOI transistor (1) according to any of claims 1 to 9.

**Patentansprüche**

1. Verfahren zum Auswerten des elektrischen Verhaltens eines FD-SOI-Transistors (1), **dadurch gekennzeichnet, dass** es folgende Schritte umfasst:

- Messen der Kapazität (102, 104, 106) und/oder der Leitfähigkeit (116, 118, 120) des FD-SOI-Transistors (1), indem eine Spannung $V_{BG} > 0$ an ein Substrat (3) auf Halbleiterbasis des FD-SOI-Transistors (1) angelegt wird, wenn der FD-SOI-Transistor (1) als NMOS ausgeführt ist, oder eine Spannung $V_{BG} < 0$ an das Substrat (3) auf Halbleiterbasis des FD-SOI-Transistors (1) angelegt wird, wenn der FD-SOI-Transistor (1) als PMOS ausgeführt ist, und zwar in Abhängigkeit von einer Spannung $V_{FG}$, die zwischen dem Gate (15) und dem Source- (9) und Drain-Bereich (11) des FD-SOI-Transistors (1) angelegt ist,
- Berechnen der theoretischen Werte der Kapazität (128, 130) und/oder der Leitfähigkeit (132) eines Transistors, der über einen Schaltkreis (300) modelliert wird, der mit dem FD-SOI-Transistor (1) äquivalent ist, und zwar in Abhängigkeit von den Werten der Spannungen $V_{FG}$ und $V_{BG}$, die an den modellierten Transistor angelegt sind, und bei verschiedenen, ausgewählten theoretischen Werten von Defektdichten $D_{it1}$, $D_{it2}$ jeweils an einer Schnittstelle zwischen einem Dielektrikum des Gates des modellierten Transistors und einem Halbleiter, der den Kanal des modellierten Transistors bilden soll, bzw. an einer Schnittstelle zwischen dem Halbleiter, der den Kanal des modellierten Transistors bilden soll, und einem vergrabenen Dielektrikum des modellierten Transistors,
- Ermitteln der Istwerte der Defektdichten $D_{it1}$, $D_{it2}$ an den entsprechenden Schnittstellen des FD-SOI-Transistors (1) durch einen Vergleich zwischen den Messwerten der Kapazität (102, 104, 106) und/oder der Leitfähigkeit (116, 118, 120) des FD-SOI-Transistors (1) und den errechneten theoretischen Werten der Kapazität (128, 130) und/oder der Leitfähigkeit (132) des modellierten Transistors bei den verschiedenen, ausgewählten theoretischen Werten der Defektdichten $D_{it1}$, $D_{it2}$ an den Schnittstellen des modellierten Transistors,
wobei dann, wenn die Leitfähigkeit (116, 118, 120) des FD-SOI-Transistors (1) gemessen ist, der Wert der Spannung $V_{SG}$ so gewählt wird, dass eine Kurve (116, 118, 120), welche die gemessene Leitfähigkeit des FD-SOI-Transistors (1) in Abhängigkeit von der Spannung $V_{FG}$ darstellt, zumindest zwei Spitzenwerte (124, 126) enthält.

2. Verfahren nach Anspruch 1, wobei die Spannung $V_{FG}$ eine Gleichspannungskomponente enthält, deren Wert zwischen etwa -2 V und 2 V liegt, sowie eine sinusförmige Wechselspannungskomponente, deren Frequenz zwischen etwa 10 kHz und 100 kHz liegt.

3. Verfahren nach einem der vorangehenden Ansprüche, wobei die Spannung $V_{BG}$ eine Gleichspannung ist, deren Wert zwischen etwa 15 V und 30 V liegt, wenn der FD-SOI-Transistor (1) als NMOS ausgeführt ist, oder zwischen etwa -15 V und -30 V liegt, wenn der FD-SOI-Transistor (1) als PMOS ausgeführt ist.

4. Verfahren nach einem der vorangehenden Ansprüche, wobei die Kapazität (102, 104, 106) und/oder die Leitfähigkeit (116, 118, 120) des FD-SOI-Transistors (1) über einen Impedanz-Analysator gemessen werden.

5. Verfahren nach einem der vorangehenden Ansprüche, wobei der zu dem FD-SOI-Transistor (1) äquivalente Schaltkreis (300) eine erste Kapazität (202) aufweist, die mit einer Gruppe von Komponenten elektrisch in Reihe geschaltet ist, welche elektrisch parallel zueinander geschaltet sind, wobei die Gruppe von Komponenten vier Kapazitäten (204, 206, 208, 212) enthalten, die Inversionskapazitäten in dem Halbleiter entsprechen, der den Kanal des modellierten Transistors auf der Seite der Schnittstellen des modellierten Transistors bilden soll, sowie Kapazitäten der Defekte an den Schnittstellen des modellierten Transistors, und zwei Leitfähigkeiten (210, 214) aufweisen, welche Leitfähigkeiten der Defekte an den Schnittstellen des modellierten Transistors entsprechen.

6. Verfahren nach einem der vorangehenden Ansprüche, wobei die errechneten theoretischen Werte der Kapazität (128, 130) und/oder der Leitfähigkeit (132) durch das Ausführen der nachfolgenden Schritte erhalten werden:

- Berechnen der theoretischen Werte von Elektronenkonzentrationen $n_{S1}$ und $n_{S2}$ an den Schnittstellen des modellierten Transistors,
- Berechnen der theoretischen Werte der charakteristischen Lebensdauer der Defekte $\tau_1$ und $\tau_2$ an den Schnittstellen des modellierten Transistors, so dass:

$$\tau_{1,2} = \sigma_{1,2} \cdot v_{th} \cdot n_{S1,2}$$

- Berechnen der theoretischen Werte der Kapazitäten $C_{it1}$ und $C_{it2}$ an den Schnittstellen des modellierten Transistors bei den verschiedenen, ausgewählten theoretischen Werten von $D_{it1}$ und $D_{it2}$, so dass:

$$C_{it1,\,2} = e.D_{it1,2} \frac{\arctan(\omega\tau_{1,2})}{\omega\tau_{1,2}}$$

- Berechnen der theoretischen Werte von Leitfähigkeiten $G_{it1}$ und $G_{it2}$ an den Schnittstellen des modellierten Transistors bei den verschiedenen, ausgewählten theoretischen Werten von $D_{it1}$ und $D_{it2}$, so dass:

$$G_{it1,\,2} = e.D_{it1,2} \frac{\ln(1+(\omega\tau_{1,2})^2)}{2\omega\tau_{1,2}}$$

- Berechnen der theoretischen Werte von Inversionsladungen $Q_{inv1}$ und $Q_{inv2}$ in dem Halbleiter, der den Kanal des modellierten Transistors bilden soll, auf der jeweiligen Seite einer jeden Schnittstelle des modellierten Transistors, so dass:

$$Q_{inv1} = -e \int_{0}^{TSi/2} n(x)dx \quad \text{und} \quad Q_{inv2} = -e \int_{TSi/2}^{TSi} n(x)dx$$

- Berechnen der theoretischen Werte von elektrischen Potentialen $\Psi_{S1}$ und $\Psi_{S2}$ in dem Halbleiter, der den Kanal des modellierten Transistors bilden soll, auf der jeweiligen Seite einer jeden Schnittstelle des modellierten Transistors,
- Berechnen der theoretischen Werte von Inversionskapazitäten $C_{inv1}$ und $C_{inv2}$ in dem Halbleiter, der den Kanal des modellierten Transistors bilden soll, auf der jeweiligen Seite einer jeden Schnittstelle des modellierten Transistors, so dass:

$$C_{inv1,2} = \frac{dQ_{inv1,2}}{d\Psi_{S1,2}}$$

- Berechnen des theoretischen Werts des Leitwerts $Y_m$ des modellierten Transistors, so dass:

$$Y_m = [(j\omega C_{ox})^{-1} + (j\omega(C_{inv1} + C_{inv2} + C_{it1} + C_{it2}) + G_{it1} + G_{it2})^{-1}]^{-1} = G_m + j\omega C_m$$

mit:

$\sigma_{1,2}$ Einfangquerschnitt an den Schnittstellen des modellierten Transistors;

$v_{th}$ thermische Geschwindigkeit der Ladungsträger;

$\omega$ : Kreisfrequenz einer sinusförmigen Wechselspannungskomponente der an den modellierten Transistor angelegten Spannung $V_{FG}$,

$n(x)$: Elektronenkonzentration bei der Tiefe x in dem Halbleiter, der den Kanal des modellierten Transistors bilden soll;

$C_{ox}$: Kapazität des Gate-Dielektrikums des modellierten Transistors;

$C_m$: Kapazität des modellierten Transistors;

$G_m$: Leitfähigkeit des modellierten Transistors;

$T_{Si}$: Dicke des Halbleiters, der den Kanal des Transistors bilden soll.

7. Verfahren nach Anspruch 6, wobei die theoretischen Werte der Elektronenkonzentrationen $n_{S1}$ und $n_{S2}$ und der elektrischen Potentiale $\Psi_{S1}$ und $\Psi_{S2}$ an den Schnittstellen des modellierten Transistors mit einer Software vom Typ Solver Poisson-Schrödinger ausgehend von den Werten der Dicke des Halbleiters, der den Kanal des modellierten Transistors bilden soll, der Dotierung des Halbleiters, der äquivalenten Oxiddicke von $SiO_2$, EOT des modellierten Transistors und von der Spannung $V_{SG}$ errechnet werden.

8. Verfahren nach einem der vorangehenden Ansprüche, wobei der Vergleich zwischen der gemessenen Leitfähigkeit (116, 118) des FD-SOI-Transistors (1) und der errechneten theoretischen Leitfähigkeit (132) des modellierten Transistors erfolgt, indem die Kurven dieser Leitfähigkeiten in Abhängigkeit von der Spannung $V_{FG}$ aufgezeichnet und übereinander gelegt werden und indem die ausgewählten theoretischen Werte der Defektdichten $D_{it1}$, $D_{it2}$ an den Schnittstellen des modellierten Transistors ermittelt werden, für welche die Kurve der errechneten theoretischen Leitfähigkeit (132) zwei Spitzenwerte (134, 136) aufweist, die im wesentlichen zwei Spitzenwerte der Kurve der gemessenen Leitfähigkeit (116) überlagern.

9. Verfahren nach einem der vorangehenden Ansprüche, wobei der Vergleich zwischen der gemessenen Kapazität (102, 104, 106) des FD-SOI-Transistors (1) und der errechneten theoretischen Kapazität (128, 130) des modellierten Transistors erfolgt, indem die Kurven dieser Kapazitäten in Abhängigkeit von der Spannung $V_{FG}$ aufgezeichnet und übereinander gelegt werden und indem dann die ausgewählten theoretischen Werte der Defektdichten $D_{it1}$, $D_{it2}$ an den Schnittstellen des modellierten Transistors ermittelt werden, bei welchen die Kurve der errechneten theoretischen Kapazität (132) zwei Wendepunkte (129, 131) aufweist, die im wesentlichen zwei Wendepunkte der Kurve der gemessenen Kapazität (102, 104) überlagen.

10. Vorrichtung (400) zum Auswerten des elektrischen Verhaltens eines FD-SOI-Transistors (1), der Mittel (402, 404) zum Durchführen eines Verfahrens zum Auswerten des elektrischen Verhaltens eines FD-SOI-Transistors (1) nach einem der Ansprüche 1 bis 9 aufweist.

FIG. 1

FIG. 2

FIG. 3

FIG. 4

FIG. 5

FIG. 6

FIG. 7

FIG. 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2009132974 A1

- EP 1591558 A

**Littérature non-brevet citée dans la description**

- **T. OUISSE et al.** Adaptation of the Charge Pumping Technique to Gated p-i-n Diodes Fabricated on Silicon on Insulator. *IEEE transactions on electron devices,* 1991, vol. 38 (6), 1432-1444
- **D.J. WOUTERS et al.** Characterization of Front and Back Si-SiO2 Interfaces in Thick- and Thin-Film Silicon-on-Insulator MOS structures by the Charge-Pumping Technique. *IEEE transactions on electron devices,* 1989, vol. 36(1 (9), 1746-1750

- **ROMANJEK K. et al.** High-k/metal Gate GeOI pMOSFET : Validation of the Lim&Fossum Model for Interface Trap Density Extraction. *IEEE International SOI Conférence Proceedings, Piscataway, NJ, USA,* 06 Octobre 2008, 147-148
- **BATUDE P. et al.** Insights on fundamental mechanisms impacting Ge metal oxide semiconductor capacitors with high-k/metal gate stacks. *Journal of Applied Physics, New York, US,* 15 Août 2007, vol. 102 (3), 34514-134514-8